# EUROPEAN PATENT APPLICATION

(11) **EP 2 500 447 A1**
(43) Date of publication of application: **19.09.2012**
(21) Application number: 10829788.8
(22) Date of filing: 28.09.2010
(51) Int. Cl.: C23C 14/34, H01L 31/04

(54) **CU-IN-GA-SE QUATERNARY ALLOY SPUTTERING TARGET**

(30) Priority: 13.11.2009 JP 2009259958
(71) Applicant: JX Nippon Mining & Metals Corporation, Tokyo 100-8164 (JP)
(72) Inventor: TAMURA Tomoya, Kitaibaraki-shi Ibaraki 319-1535 (JP); TAKAMI Hideo, Kitaibaraki-shi Ibaraki 319-1535 (JP); IKISAWA Masakatsu, Kitaibaraki-shi Ibaraki 319-1535 (JP); SAKAMOTO Masaru, Kitaibaraki-shi Ibaraki 319-1535 (JP); SUZUKI Ryo, Kitaibaraki-shi Ibaraki 319-1535 (JP)
(74) Representative: Hoarton, Lloyd Douglas Charles
(86) International application number: PCT/JP2010/066820
(87) International publication number: WO 2011/058828

(57) **Abstract**

A quaternary alloy sputtering target made of copper (Cu), indium (In), gallium (Ga) and selenium (Se), wherein the Cu-In-Ga-Se sputtering target has a composition that is represented by a composition formula of CuIn₁₋ₓGaₓSe_{2-y} (provided that x and y respectively represent atomic ratios), a composition range of 0 < x ≤ 0.5, 0 ≤ y ≤ 0.04, and a relative density of 90% or higher. Specifically, a CIGS quaternary alloy sputtering target of high density and low oxygen concentration, and a CIGS quaternary alloy sputtering target comprising the intended bulk resistance.

## Description

### TECHNICAL FIELD

The present invention relates to a Cu-In-Ga-Se, which hereinafter referred to as "CIGS", quaternary alloy sputtering target that is used upon forming a CIGS quaternary alloy thin film to become a light-absorbing layer of thin film solar cells.

### BACKGROUNG ART

In recent years, the technical development of CIGS-based solar cells of high conversion efficiency for use as thin film solar cells has advanced. As a method of producing the light-absorbing layer of such thin film solar cells, the vapor-deposition technique and the selenization method are known. Nevertheless, while the solar cells produced via the vapor-deposition technique are advantageous of having high conversion efficiency, they also have drawbacks of low deposition rate, high cost, and low productivity. Meanwhile, while the selenization method is suitable for industrial mass production, after preparing a laminated film of Cu-Ga and In, a complex and dangerous process of performing heat treatment and selenization in a selenium hydride atmosphere gas is required, and there are drawbacks in terms of cost and time.

Thus, attempts are being made for preparing a CIGS quaternary alloy light-absorbing layer in a single sputtering process by using a CIGS quaternary alloy sputtering target. Nevertheless, the current reality is that a CIGS quaternary alloy sputtering target that suits to form a light-absorbing layer has not yet been achieved.

Patent Document 1 discloses a method of producing a CIGS quaternary alloy sputtering target by placing In into Cu-Se-based binary alloy molten metal, thereafter sequentially placing Ga therein to form a CIGS quaternary alloy ingot, thereafter subjecting the ingot to dry grinding, and then hot-pressing the pulverized powder.
Nevertheless, in relation to the CIGS quaternary alloy sputtering target obtained based on the foregoing production method, Patent Document 1 fails to clarify the density, oxygen concentration, bulk resistance and other important characteristics of a sputtering target.

Moreover, Non-Patent Document 1 discloses a method of producing a CIGS quaternary alloy sputtering target by preparing mechanical alloy powder to become the nanopowder raw material, and thereafter performing HIP treatment thereto, and further discloses the characteristics of the obtained target.
Nevertheless, with respect to the characteristics of the CIGS quaternary alloy sputtering target obtained based on the foregoing production method, it fails to clarify any specific numerical values of the density although Non-Patent Document 1 qualitatively describes that the density was high.

Moreover, while it is anticipated that the oxygen concentration is high since nanopowder is being used, Non-Patent Document 1 also fails to clarify the oxygen concentration of the sintered compact. Moreover, Non-Patent Document 1 also lacks any description regarding the bulk resistance which affects the sputtering characteristics. In addition, since costly nanopowder is being used as the raw material, it is inappropriate as a solar cell material which is demanded of low cost.

Moreover, Non-Patent Document 2 discloses a sintered compact having a composition of Cu(In0.8Ga0.2)Se₂, density of 5.5 g/cm3, and relative density of 97%.
Nevertheless, as its production method, the only description that is provided is that the uniquely synthesized raw material powder is sintered via hot press, and the specific production method is not indicated. Moreover, it fails to provide any description regarding the oxygen concentration and bulk resistance of the obtained sintered compact.

### [Prior Art Documents]

[Patent Document 1] Japanese Unexamined Patent Application Publication No. 2008-163367

[Non-Patent Document 1] Thin Solid Films 332(1998)340-344
[Non-Patent Document 2] Electronic Material, November 2009, Pages 42 to 45

### SUMMARY OF THE INVENTION

### [Problem to be Solved by the Invention]

An object of the present invention is to provide a CIGS quaternary alloy sputtering target of high density and low oxygen concentration, as well as a CIGS quaternary alloy sputtering target comprising the intended bulk resistance.

### [Means to Solve the Problem]

In order to achieve the foregoing object, as a result of intense study conducted by the present inventors, it was discovered that the density of the CIGS quaternary alloy sputtering target is associated with the synthesis temperature profile upon preparing the raw material powder and the preset temperature during the hot press; that is, the target can be highly densified by setting the appropriate synthesis temperature, rate of temperature increase, holding time and so on.

Moreover, the present inventors additionally discovered that the oxygen concentration of the CIGS quaternary alloy sputtering target is associated with the grain size of the raw material powder and the preset temperature of the subsequent process; that is, the oxygen concentration of the target can be reduced by using raw material powder of an appropriate average grain size and setting the temperature of the subsequent process to an appropriate temperature.

In addition, the present inventors and others further discovered that the bulk resistance and its variation are associated with the existence of a heterogeneous phase in the CIGS quaternary alloy sputtering target; that is, the intended bulk resistance can be obtained and the variation in such resistance value can be reduced by optimizing the raw material synthesis and hot press conditions. The present inventors thereby completed the present invention.

Specifically, the present invention provides:
1. A quaternary alloy sputtering target made of copper (Cu), indium (In), gallium (Ga) and selenium (Se), wherein the Cu-In-Ga-Se sputtering target has a composition that is represented by a composition formula of CuIn₁₋ₓGaₓSe_{2-y} (provided that x and y respectively represent atomic ratios), a composition range of 0 < x ≤ 0.5, 0 ≤ y ≤ 0.04, and a relative density of 90% or higher.

The present invention additionally provides:
2. The Cu-In-Ga-Se quaternary alloy sputtering target according to 1 above, wherein the oxygen concentration is 200 wtppm or less;
3. The Cu-In-Ga-Se quaternary alloy sputtering target according to 1 or 2 above, wherein the bulk resistance is within a range of 50 to 100 Ωcm;
4. The Cu-In-Ga-Se quaternary alloy sputtering target according to any one of 1 to 3 above, wherein variation in the bulk resistance is ±5% or less in the target face;
5. The Cu-In-Ga-Se quaternary alloy sputtering target according to any one of 1 to 4 above, wherein the average grain size is 20 to 100 µm.

The present invention further provides:
6. The Cu-In-Ga-Se sputtering target according to any one of 1 to 5 above, wherein the relative density is 98% or higher; and
7. The Cu-In-Ga-Se sputtering target according to any one of 1 to 5 above which is produced by mixing and synthesizing shot- or bar-shaped Cu, In, Ga and Se as starting raw materials, passing the synthetic raw material through a sieve to perform size control, and thereafter sintering the synthesized powder via hot press (HP).

### [Effect of the Invention]

The CIGS quaternary alloy sputtering target of the present invention yields superior effects of being free of abnormal discharge even when sputtered for a long period, and being able to produce a film having superior in-plane uniformity of the film composition.

### DETAILED DESCRIPTION OF THE INVENTION

The composition range of In in the CIGS quaternary alloy sputtering target shall be 0 < x ≤ 0.50 in the composition formula of Culn₁₋ₓGaₓSe_{2-y} (provided that x and y respectively represent atomic ratios).
The band gap of CIGS will increase if x is increased and this is preferable since the matching with the solar spectrum will become favorable, but if x exceeds 0.5, it will exceed the appropriate band gap for absorbing the solar spectrum.
Accordingly, the appropriate range as the CIGS light-absorbing layer is 0 < x ≤ 0.50. Note that the respective compositions can be obtained via the ICP analysis method.

The composition range of Se in the CIGS quaternary alloy sputtering target shall be 0 ≤ y ≤ 0.04 in the composition formula of CuIn₁₋ₓGaₓSe_{2-y} (provided that x and y respectively represent atomic ratios).
y represents the so-called selenium deficiency, and the greater the value of y is, the greater the selenium deficiency is, which will deviate from the intended composition, and consequently the relative density of the target will also decrease.

Since selenium has high vapor pressure and the composition obtained after synthesizing the raw materials will change depending on the temperature setting, in order to obtain the intended y value, the temperature setting during the synthesis must be controlled appropriately. For .example, selenium defect tends to occur if the rate of temperature increase from 100°C to 400°C during the synthesis is increased. Note that the concentration of selenium can be obtained via the ICP analysis method.

One important point regarding the CIGS quaternary alloy sputtering target of the present invention is that the relative density of the sintered compact is 90% or higher, preferably 98% or higher, and more preferably 99% or higher. In order to increase the relative density, it is necessary to prepare the raw material of an appropriate composition ratio, and thereafter set the holding temperature during the hot press to be a high and appropriate temperature. Note that the relative density is the ratio of the value obtained by dividing the actual absolute density of the sintered compact target measured via the Archimedean method by the theoretical density of the target of that composition.

The relative density of the target being low means that there are numerous internal pores in the target, and splashes and abnormal discharge originating around the pores tend to occur upon the exposure of such internal pores during the sputtering. Thus, the generation of particles on the film will increase and the formation of unevenness on the surface will advance quickly, whereby abnormal discharge and the like originating from the surface protrusions (nodules) tend to occur. This is one of the causes that deteriorate the conversion efficiency of the CIGS solar cells.

Another important point regarding the CIGS quaternary alloy sputtering target of the present invention is that the oxygen content is 200 ppm or less. Thus, it is necessary to prevent the raw material powder from coming into contact with the atmosphere as much as possible, and use raw materials having a grain size that is not too fine. If the oxygen concentration is high, oxygen will bond with the metal components of the CIGS quaternary alloy, and oxides are easily formed.
Since oxides have higher electrical resistance than metal, differences in the resistance will occur on the target face beyond the level of the variation in resistance of a single composition, whereby surface unevenness caused by the abnormal discharge originating from the high resistance portion and the difference in the sputter rate occurs easily, and may become the cause of the generation of abnormal discharge and particles.

Yet another important point regarding the CIGS quaternary alloy sputtering target of the present invention is that the bulk resistance is 50 to 100 Ωcm, preferably 50 to 80 Ωcm. If the bulk resistance is high, it may cause abnormal discharge and, therefore, the bulk resistance is preferably low. However, when the bulk resistance is lower than 50 Ωcm, the cause thereof is that the relative density of the target is low, or that there is a heterogeneous phase of low resistivity other than CIGS, and in either case this is undesirable since it will cause problems such as the generation of nodules or abnormal discharge during sputtering that is performed for a long period, or variation in the film composition.

Yet another important point regarding the CIGS quaternary alloy sputtering target of the present invention is that the variation in the bulk resistance is ±5% or less in the target face. Variation in the bulk resistance means that a heterogeneous phase is contained in the target face and that there is unevenness in the distribution thereof, and this is undesirable since it will cause problems such as abnormal discharge and variation in the film composition. Note that variation in the bulk resistance can be obtained based on the ratio of the value obtained by measuring the bulk resistance at 10 points on the target face, and dividing, by the average value, the difference between the minimum value or the maximum value and the average value.

Yet another important point regarding the CIGS quaternary alloy sputtering target of the present invention is that the average crystal grain size is 20 to 100 µm, preferably 20 to 70 µm, and more preferably 20 to 60 µm. This is because, if the average grain size is too small, the oxygen concentration tends to become too high. Moreover, in order to achieve such a small grain size, the grain size of the raw material powder needs to be extremely small. However, since raw material powder having such a small grain size is extremely costly, it is inappropriate for use in solar cells which are demanded of low cost.

Contrarily, if the average grain size is too large, considerable unevenness is easily formed on the surface due to the difference in the sputter rate based on the crystal plane orientation since the respective crystal grains are of random orientation, and the generation of particles caused by the abnormal discharge originating therefrom tends to increase.
Note that the average grain size can be obtained by the planimetric method after lightly etching the target surface as needed and clarifying the grain boundary.

The Cu-In-Ga-Se sputtering target of the present invention can be obtained by mixing and synthesizing shot- or bar-shaped Cu, In, Ga and Se as starting raw materials, passing the synthetic raw material through a sieve to perform size control, and thereafter sintering the synthesized powder via hot press (HP). There is no particular limitation on the shape of the raw material, but it could be said that shot- or bar-shaped Cu, In, Ga and Se are preferably used as the raw materials since the oxygen concentration will increase if powder is used.
Moreover, the status of abnormal discharge and the like can be examined by processing a CIGS sintered compact, for instance, to have a diameter of 6 inches and a thickness of 6 mm, bonding brazing filler metal of indium or the like to the backing plate, and sputtering this to observe the actual condition thereof.

### [Examples]

The Examples and the Comparative Examples of the present invention are now explained. Note that the following Examples merely illustrate representative examples, and the present invention should not be limited to these Examples. Thus, the present invention should be interpreted within the scope of the technical concept that is described in the specification.

### (Example 1)

Cu, In, Ga and Se as raw materials were weighed so that x and y respectively become 0.2 and 0 in the composition formula of CuIn₁₋ₓGaₓSe_{2-y}. Note that, here, the concentration of the respective raw materials; namely, the concentration of Cu, In, Ga and Se will be 25%, 20%, 5% and 50%, respectively.

These raw materials were placed in a quartz ampule; the inside thereof was vacuumed and thereafter sealed, and set in a furnace and synthesized. As the temperature profile, the rate of temperature increase from room temperature to 100°C was set to 5°C/min, the rate of temperature increase was thereafter set to 1°C/min up to 400°C, the rate of temperature increase was thereafter set to 5°C/min up to 550°C, the rate of temperature increase was thereafter set to 1.66°C/min up to 650°C, and, after being held at 650°C for 8 hours, the inside of the furnace was cooled across a period of 12 hours to reach room temperature.

The CIGS synthetic raw material powder that was obtained as described above was passed through a sieve of 120 mesh, and subject to hot press (HP). The HP conditions were as follows; namely, the rate of temperature increase from room temperature to 750°C was set to 10°C/min, and, after being held at 750°C for 3 hours, the heating was stopped and the inside of the furnace was cooled naturally. As the pressure, bearing of 200 kgf/cm² was added for 2 hours and 30 minutes, 30 minutes after reaching 750°C, and the application of pressure was stopped simultaneously with the end of heating.

The relative density of the obtained CIGS sintered compact was 98.9%, the oxygen concentration was 180 ppm, the bulk resistance was 65 Ωcm, the variation in the bulk resistance was 3.8%, and the average grain size was 60 µm.

This sintered compact was processed into a disk-shaped sputtering target having a diameter of 6 inches and a thickness of 6 mm, and sputtered. The sputter power was direct current (DC) 1000W, the atmosphere gas was argon, the gas flow rate was 50 sccm, and the pressure during sputtering was 0.5 Pa. Upon counting the number of abnormal discharges during one hour period after performing sputtering for 20 hours to 21 hours, the result was zero.

### (Example 2 to Example 6)

The results upon preparing targets of different components based on the same method as Example 1 and evaluating the sputtering process are summarized in Table 1. As shown in Table 1, x which shows the concentration (atomic ratio) of Ga in Example 2 to Example 6 was within a range of 0 < x ≤ 0.5, and y which shows the deficiency level of selenium was within a range of 0 ≤ y ≤ 0.05.

As shown in Table 1, the relative density of the CIGS sintered compact of Example 2 was 98.8%, the oxygen concentration was 187 ppm, the bulk resistance was 72 Ωcm, the variation in the bulk resistance was 3.6%, and the average grain size was 76 µm. Moreover, with respect to the abnormal discharge count, upon counting the number of abnormal discharges during one hour period after performing sputtering for 20 hours to 21 hours, the result was zero.

The relative density of the CIGS sintered compact of Example 3 was 98.8%, the oxygen concentration was 183 ppm, the bulk resistance was 80 Ωcm, the variation in the bulk resistance was 4.2%, and the average grain size was 55 µm. Moreover, with respect to the abnormal discharge count, upon counting the number of abnormal discharges during one hour period after performing sputtering for 20 hours to 21 hours, the result was zero.

The relative density of the CIGS sintered compact of Example 4 was 99.2%, the oxygen concentration was 183 ppm, the bulk resistance was 59 Ωcm, the variation in the bulk resistance was 3.2%, and the average grain size was 49 µm. Moreover, with respect to the abnormal discharge count, upon counting the number of abnormal discharges during one hour period after performing sputtering for 20 hours to 21 hours, the result was zero.

The relative density of the CIGS sintered compact of Example 5 was 98.3%, the oxygen concentration was 188 ppm, the bulk resistance was 62 Ωcm, the variation in the bulk resistance was 3.8%, and the average grain size was 83 µm. Moreover, with respect to the abnormal discharge count, upon counting the number of abnormal discharges during one hour period after performing sputtering for 20 hours to 21 hours, the result was once.

The relative density of the CIGS sintered compact of Example 6 was 98.1 %, the oxygen concentration was 186 ppm, the bulk resistance was 56 Ωcm, the variation in the bulk resistance was 3.9%, and the average grain size was 66 µm. Moreover, with respect to the abnormal discharge count, upon counting the number of abnormal discharges during one hour period after performing sputtering for 20 hours to 21 hours, the result was zero.

Accordingly, regarding the target characteristics, the relative density was 90% or higher, in certain cases the relative density was 98% or higher, the oxygen concentration was 200 ppm or less, the bulk resistance was within a range of 50 to 100 Ωcm, variation in the bulk resistance was 5% or less, and the average grain size was within a range of 20 to 100 µm. Moreover, the number of abnormal discharges during sputtering was extremely low at once or less, and favorable results were obtained.

**[Table 1]**

| | | | | | | | | |
|---|---|---|---|---|---|---|---|---|
| | Composition | Composition | Relative Density | Oxygen Concentration | Bulk Resistance | Bulk Resistance Variation | Average Grain Size | Abnormal Discharge Count |

| | x | y | (%) | (wtppm) | (Ωcm) | (%) | (µm) | (No. of Times) |
|---|---|---|---|---|---|---|---|---|
| Example 1 | 0.20 | 0 | 98.9 | 180 | 65 | 3.8 | 60 | 0 |
| Example 2 | 0.35 | 0 | 98.8 | 187 | 72 | 3.6 | 76 | 0 |
| Example 3 | 0 50 | 0 | 98.8 | 183 | 80 | 4.2 | 55 | 0 |
| Example 4 | 0.05 | 0 | 99.2 | 183 | 59 | 3.2 | 49 | 0 |
| Example 5 | 0.20 | 0 02 | 98.3 | 188 | 62 | 3.8 | 83 | 1 |
| Example 6 | 0 20 | 0.04 | 98.1 | 186 | 56 | 3.9 | 66 | 1 |
| Comparative Example 1 | 0.20 | 0 1 | 93.5 | 197 | 33 | 7.8 | 77 | 25 |
| Comparative Example 2 | 0.20 | 0 | 83.5 | 185 | 38 | 9.7 | 80 | 38 |
| Comparative Example 3 | 0.20 | 0 | 99.0 | 980 | 93 | 5.7 | 0.15 | 17 |
| Comparative Example 4 | 0.20 | 0 | 98.8 | 1350 | 125 | 8.3 | 0 08 | 45 |
| Comparative Example 5 | 0 20 | 0 | 86.2 | 190 | 28 | 9.5 | 68 | 33 |

### (Comparative Example 1)

A target was prepared based on the same method as Example 1 other than increasing the rate of temperature from 100°C to 400°C to 5°C/min, rather than 1°C/min, upon synthesizing the raw material powder. The amount of deficient selenium of the prepared target; that is, y, was extremely large at 0.1. The relative density was 80.6%, the oxygen concentration was 197 ppm, the bulk resistance was 33 Ωcm, the variation in the bulk resistance was 7.8%, and the average grain size was 77 µm. The abnormal discharge count during sputtering was 25 times.

### (Comparative Example 2)

A target was prepared based on the same method as Example 1 other than lowering the holding temperature during the hot press to 650°C, rather than 750°C. The relative density of the prepared target was 81.1 %, the oxygen concentration was 185 ppm, the bulk resistance was 38 Ωcm, the variation in the bulk resistance was 9.7%, and the average grain size was 80 µm. The abnormal discharge count during sputtering was 38 times.

### (Comparative Example 3)

A target was prepared based on the same method as Example 1 other than using nanopowder having an average grain size of 100 to 200 nm as the raw material powder. The relative density of the prepared target was 97.5%, the oxygen concentration was 980 ppm, the bulk resistance was 93 Ωcm, the variation in the bulk resistance was 5.7%, and the average grain size was 0.15 µm. The abnormal discharge count during sputtering was 17 times.

### (Comparative Example 4)

A target was prepared based on the same method as Example 1 other than using nanopowder having an average grain size of 50 to 150 nm as the raw material powder. The relative density of the prepared target was 97.9%, the oxygen concentration was 1350 ppm, the bulk resistance was 125 Ωcm, the variation in the bulk resistance was 8.3%, and the average grain size was 0.08 µm. The abnormal discharge count during sputtering was 45 times.

### (Comparative Example 5)

A target was prepared based on the same method as Example 1 other than lowering the synthesis holding temperature upon synthesizing the raw material powder to 600°C, rather than 650°C/min. The relative density of the prepared target was 86.2%, the oxygen concentration was 190 ppm, the bulk resistance was 28 Ωcm, the variation in the bulk resistance was 9.5%, and the average grain size was 68 µm. The abnormal discharge count during sputtering was 33 times.

### INDUSTRIAL APPLICABILITY

Since the CIGS quaternary alloy sputtering target obtained by the present invention has a density of 90% or higher and an oxygen concentration of 200 wtppm or less, superior effects are yielded in that hardly any abnormal discharge occurs even when this is used and sputtered for a long period upon forming a film with a single sputtering process, and it is possible to obtain a film with superior in-plane uniformity of the film composition. In particular, the present invention is useful as a light-absorbing layer material of thin film solar cells, and as a CIGS quaternary alloy thin film material of high conversion efficiency.

## Claims

1. A quaternary alloy sputtering target made of copper (Cu), indium (In), gallium (Ga) and selenium (Se), wherein the Cu-In-Ga-Se sputtering target has a composition that is represented by a composition formula of CuIn₁₋ₓGaₓSe_{2-y} (provided that x and y respectively represent atomic ratios), a composition range of 0 < x ≤ 0.5, 0 ≤ y ≤ 0.04, and a relative density of 90% or higher.

2. The Cu-In-Ga-Se quaternary alloy sputtering target according to claim 1, wherein the oxygen concentration is 200 wtppm or less.

3. The Cu-In-Ga-Se quaternary alloy sputtering target according to claim 1 or claim 2, wherein the bulk resistance is within a range of 50 to 100 Ωcm.

4. The Cu-In-Ga-Se quaternary alloy sputtering target according to any one of claims 1 to 3, wherein variation in the bulk resistance is ±5% or less in the target face.

5. The Cu-In-Ga-Se quaternary alloy sputtering target according to any one of claims 1 to 4, wherein the average grain size is 20 to 100 µm.

6. The Cu-In-Ga-Se sputtering target according to any one of claims 1 to 5, wherein the relative density is 98% or higher.

7. The Cu-In-Ga-Se sputtering target according to any one of claims 1 to 5 which is produced by mixing and synthesizing shot- or bar-shaped Cu, In, Ga and Se as starting raw materials, passing the synthetic raw material through a sieve to perform size control, and thereafter sintering the synthesized powder via hot press (HP).
